# EUROPEAN PATENT SPECIFICATION

(11) **EP 1 612 857 B1**
(45) Date of publication and mention of the grant of the patent: **01.08.2018**
(21) Application number: 04720167.8
(22) Date of filing: 12.03.2004
(51) Int. Cl.: H01L 21/31, C23C 16/44

(54) **CVD APPARATUS AND METHOD FOR CLEANING CVD APPARATUS**
CVD-ANLAGE UND REINIGUNGSVERFAHREN FÜR EINE CVD-ANLAGE
APPAREIL DE DEPOT CHIMIQUE EN PHASE VAPEUR ET PROCEDE DE NETTOYAGE D'UN TEL APPAREIL

(30) Priority: 14.03.2003 JP 2003070337; 30.06.2003 JP 2003187141
(43) Date of publication of application: 04.01.2006
(73) Proprietor: Canon Anelva Corporation, Kawasaki-shi Kanagawa 215-8550 (JP); Renesas Electronics Corporation, Tokyo 135-0061 (JP)
(72) Inventor: WANI, E. c/o CANAON ANELVA CORPORATION, Tokyo 1838508 (JP); SAKAI, K. c/o MATUSHITA ELECTRIC INDUSTRIAL CO., LTD, Osaka-shi 5406319 (JP); OKURA, S. c/o MITSUBISHI DENKI KABUSHIKI KAISHA, Kanagawa 2478501 (JP); SAKAMURA, M., Tatebayashi, Gunma 3740007 (JP); ABE, K. c/o ULVAC , INC., Kanagawa 2538543 (JP); MURATA, H. c/o TOKYO ELECTRON LIMITED TBS Broadcast, Tokyo 1078481 (JP); KAMEDA, K. c/o HITACHI KOKUSAI ELECTRIC INC., Tokyo 1878511 (JP)
(74) Representative: Dehns
(86) International application number: PCT/JP2004/003258
(87) International publication number: WO 2004/082008

(56) References cited:
- JP-A- 7 288 248
- JP-A- 8 176 828
- JP-A- 10 072 672
- JP-A- 11 204 436
- JP-A- 2002 158 181
- JP-A- 2002 517 740
- JP-U- 1 113 332
- US-A1- 2003 001 134

## Description

### TECHNICAL FIELD

The present invention relates to a chemical vapor deposition (CVD) apparatus for forming a uniform thin film of high quality, for example, silicon oxide (SiO₂) or silicon nitride (Si₃N₄) on the surface of a base material for a semiconductor such as a silicon wafer.

In more detail, the present invention relates to a CVD apparatus which can execute cleaning for removing a by-product stuck to the internal wall of a CVD chamber after a thin film forming process, and a CVD apparatus cleaning method using the same, and a CVD apparatus capable of reducing the amount of the stuck by-product and a film forming method using the CVD apparatus.

### BACKGROUND ART

Conventionally, a thin film such as silicon oxide (SiO₂) or silicon nitride (Si₃N₄ or the like) has been used widely for a semiconductor device such as a thin film transistor, a photoelectric converting device and the like. The following three kinds of methods are mainly used for a method of forming the thin film such as the silicon oxide or the silicon nitride.

### (1) Physical vapor phase film forming method such as sputtering or vacuum deposition

More specifically, in the method, a solid thin film material is set to be an atom or an atomic group to be a physical technique and is deposited over a surface on which a film is to be formed, and a thin film is thus formed.

### (2) Thermal CVD method

More specifically, in the method, the thin film material of a gas is set to have a high temperature, and a chemical reaction is thus caused to form a thin film.

### (3) Plasma CVD method

More specifically, in the method, the thin film material of a gas is changed into a plasma and a chemical reaction is thus caused to form a thin film.

In particular, the plasma CVD method (plasma enhanced chemical vapour deposition) in (3) has been used widely because a dense and uniform thin film can be efficiently formed (see Japanese Laid-Open Patent Publication No. Hei 9-69504 publication and Japanese Laid-Open Patent Publication No. 2002-343787 publication).

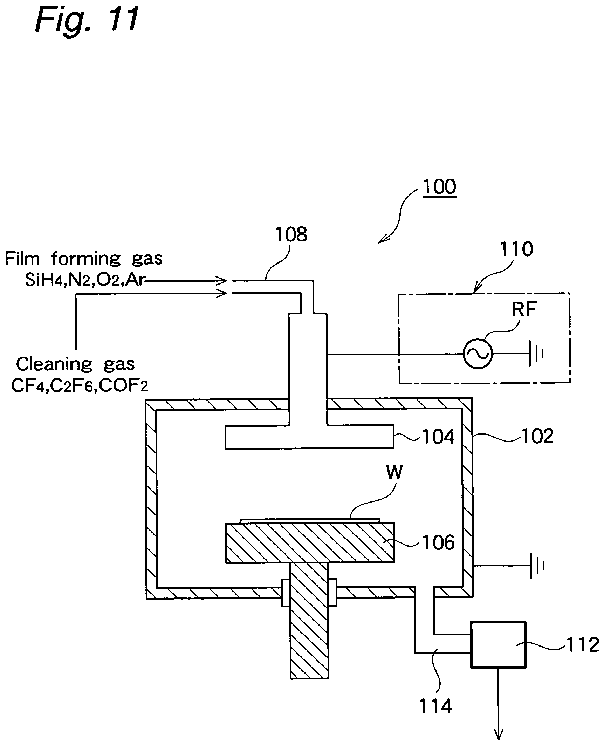

A plasma CVD apparatus 100 to be used in the plasma CVD method is generally constituted as shown in Fig. 11.

More specifically, the plasma CVD apparatus 100 comprises a CVD chamber 102 maintained under reduced pressure, and an upper electrode 104 and a lower electrode 106 are provided to be opposed to each other at a constant interval in the CVD chamber 102. A film forming gas supply path 108 connected to a film forming gas source which is not shown is connected to the upper electrode 104 in such a manner that a film forming gas is supplied into the CVD chamber 102 through the upper electrode 104.

Moreover, a high frequency applying device 110 for applying a high frequency is connected to the vicinity of the upper electrode 104 in the CVD chamber 102. Furthermore, an exhaust path 114 for discharging an exhaust gas through a pump 112 is connected to the CVD chamber 102.

In the plasma CVD apparatus 100 thus constituted, for example, monosilane (SiH₄), N₂O, N₂, O₂, Ar or the like in the formation of the film of the silicon oxide (SiO₂) and monosilane (SiH₄), NH₃, N₂, O₂, Ar or the like in the formation of the film of the silicon nitride (Si₃N₄ or the like) are introduced through the film forming gas supply path 108 and the upper electrode 104 into the CVD chamber 102 maintained in a pressure reducing state of 130 Pa.

In this case, for example, a power having a high frequency of 13.56 MHz is applied through the high frequency applying device 110 to a portion between the electrodes 104 and 106 provided opposite to each other in the CVD chamber 102, thereby generating a high frequency electric field. In the electric field, an electron is caused to collide with the neutral molecule of a film forming gas so that a high frequency plasma is formed and the film forming gas is decomposed into an ion and a radical.

By the action of the ion and the radical, a thin silicon film is formed on the surface of a semiconductor product W such as a silicon wafer which is provided on the lower electrode 106 to be one of the electrodes.

In such a plasma CVD apparatus 100, a thin film material such as SiO₂ or Si₃N₄ is also stuck and deposited onto the surface of an internal surface, an electrode or the like in the CVD chamber 102 other than the semiconductor product W on which a film is to be formed by a discharge in the CVD chamber 102 so that a by-product is formed in a film forming process.

The by-product is peeled by a dead weight, a stress or the like when it grows to have a constant thickness, and particulates are mixed as foreign matters into a semiconductor product, thereby causing a contamination in the film forming process. Thus, a thin film of high quality cannot be manufactured so that the disconnection and short circuit of a semiconductor circuit might be caused, and furthermore, a yield or the like might also be reduced.

For this reason, conventionally, a by-product is removed by using a cleaning gas to which a fluorine containing compound such as CF₄, C₂F₆ or COF₂ and O₂ or the like are added if necessary, for example, in order to remove the by-product at any time after the film forming process is ended in the plasma CVD apparatus 100.

More specifically, in the conventional cleaning method of the plasma CVD apparatus 100 using a cleaning gas which has been described in the Japanese Laid-Open Patent Publication No. Hei 9-69504 publication, as shown in Fig. 11, a cleaning gas constituted by a fluorine containing compound such as CF₄, C₂F₆ or COF₂ is introduced in place of a film forming gas in the film formation together with a gas such as O₂ and/or Ar through the film forming gas supply path 108 and the upper electrode 104 into the CVD chamber 102 maintained under reduced pressure after the film forming process is ended.

In the same manner as in the film formation, a high frequency power is applied through the high frequency applying device 110 to a portion between the electrodes 104 and 106 provided opposite to each other in the CVD chamber 102, thereby generating a high frequency electric field, and an electron in the electric field is caused to collide with the neutral molecule of the cleaning gas to form a high frequency plasma so that the cleaning gas is decomposed into an ion and a radical.

Then, the ion and the radical react to a by-product such as SiO₂ or Si₃N₄ which is stuck and deposited onto the surface of the internal wall, the electrode or the like in the CVD chamber 102 so that the by-product is changed into a gas as SiF₄. Consequently, the SiF₄ is discharged together with an exhaust gas to the outside of the CVD chamber 102 through the exhaust path 114 by means of the pump 112.

Moreover, the Japanese Laid-Open Patent Publication No. 2002-343787 publication has employed a structure in which a lower electrode can be moved by means of a moving mechanism to cause a lower electrode to freely approach or separate from an upper electrode in such a manner that a plasma having a high density can be generated when a film forming process and cleaning are to be carried out, and a small space for a plasma generation and a plasma treatment is formed between the upper electrode and the lower electrode maintained to approach the upper electrode.

In the Japanese Laid-Open Patent Publication No. 2002-343787 publication, when the internal surface of the chamber is exposed to the space for the plasma generation and the plasma treatment which is formed as the small space, a film is easily stuck to the exposed surface so that cleaning becomes troublesome and the efficiency of the cleaning is reduced. In order to prevent the troubles, therefore, a portion placed from the main surface of the upper electrode of the film forming chamber by a predetermined distance is covered with an insulator ring to suppress the expansion of a plasma, thereby reducing the amount of a film stuck to the internal surface in the film forming chamber.

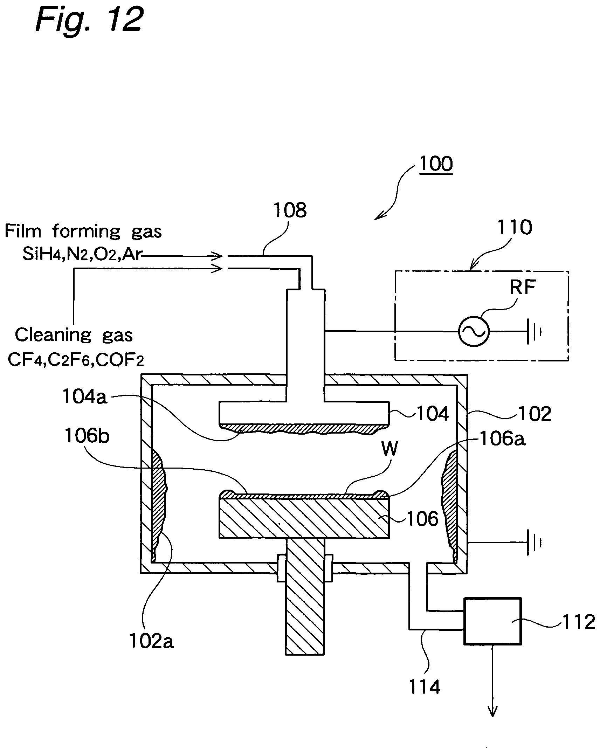

In the CVD chamber 102, after the execution of the film forming process, the by-product such as SiO₂ or Si₃N₄ is stuck and deposited in a large amount onto a lower surface 104a of the upper electrode 104, a side wall 102a of the CVD chamber 102 and a surrounding portion 106a of the lower electrode 106 as shown in Fig. 12.

In such a cleaning method, however, a surface 106b of the lower electrode 106 is exposed after the semiconductor product W is delivered out, and the surface of the lower electrode 106 is exposed to the ion and plasma of a cleaning gas for a long time.

Consequently, a corrosion on the surface of the lower electrode 106 progresses so that the lower electrode 106 is damaged. As a result, the function of the CVD apparatus itself is also damaged.

On the other hand, in a semiconductor apparatus manufacturing process, the by-product stuck into the CVD chamber is subjected to the cleaning when the formation of the film is executed by the plasma CVD. However, the gas to be used in the cleaning has a high global warming coefficient and is not completely decomposed. When the gas is discharged as it is, therefore, global warming is caused.

The document JP 11-204436 A describes a CVD plasma cleaning process and a CVD film deposition process. For this reason, it is possible to propose some methods in order to reduce the amount of a global warming gas discharged from the plasma CVD. For example, there are a method of using a gas having a low global warming coefficient and a method of introducing harm removing equipment. In order to change the gas and to introduce the harm removing equipment, an investigation is required in respect of a study and a cost.

In consideration of such actual circumstances, it is an object of the present invention to provide a CVD apparatus capable of efficiently removing a by-product such as SiO₂ or Si₃N₄ which is stuck and deposited onto the surface of an internal wall, an electrode or the like in a CVD chamber in a film forming process, and furthermore, executing cleaning having a small damage over an upper electrode and a counter electrode stage (a lower electrode) and manufacturing a thin film of high quality, and a CVD apparatus cleaning method using the same.

Moreover, it is an object of the present invention to provide a CVD apparatus capable of reducing the amount of a by-product such as SiO₂ or Si₃N₄ which is stuck and deposited onto the surface of an internal wall, an electrode or the like in a CVD chamber in a film forming process, resulting in a reduction in a time required for cleaning in the cleaning and a decrease in the amount of the discharge of a gas having a high global warming coefficient, and a film forming method using the CVD apparatus.

### DISCLOSURE OF THE INVENTION

The present invention has been made in order to solve the problems of the conventional art described above and to attain the objects, and provides a CVD apparatus as defined in claim 6. Moreover, the present invention provides a CVD apparatus as defined in claim 1. Thus, the frequency of the RF to be applied to the RF electrode can be switched into the first frequency to be applied for forming a film and the second frequency. By using the first frequency, therefore, a plasma having a high density can be generated on a suitable condition for forming a film and a thin film of high quality can be manufactured.

In addition, in the execution of the plasma cleaning, it is possible to generate a plasma having a high density on a suitable condition for the plasma cleaning by carrying out the switching to the second frequency. Thus, it is possible to efficiently remove a by-product such as SiO₂ or Si₃N₄ which is stuck and deposited onto the surface of an internal wall, an electrode or the like in the CVD chamber in a film forming process.

By such a structure, when the deposited film is to be formed on the surface of the substrate and the cleaning gas is to be then introduced to carry out the plasma cleaning over the inside of the CVD chamber, the RF having a comparatively low frequency as the first frequency is applied to the RF electrode at the first step. Consequently, the cleaning is carried out in such a state that the deposited film to be cleaned is left. Thus, the influence of a damage is maintained to be small. Consequently, it is possible to remove most of the by-product such as SiO₂ or Si₃N₄ which is stuck and deposited onto the surface of the internal wall, the electrode or the like in the CVD chamber in the film forming process.

After most of the by-product is removed at the first step, the RF having a comparatively high frequency as the second frequency is applied to the RF electrode at the second step. Consequently, it is possible to completely remove the residual by-product which is stuck. In order to utilize a comparatively high frequency, moreover, it is possible to reduce a damage over the chamber itself.

In addition, it is possible to relieve a damage over the upper electrode and the counter electrode stage by carrying out the plasma cleaning at the second step in a short time.

Moreover, the present invention is characterized in that an electrode interval is changed at the first step and the second step.

Thus, the electrode interval is changed at the first step and the second step. Consequently, it is possible to generate a plasma having a high density and to remove a by-product stuck to the upper electrode, the counter electrode and the upper side wall of the CVD chamber by reducing a gap between the electrodes at the first step, for example.

By more increasing the gap between the electrodes at the second step than that in the first step it is possible to carry out the cleaning over the side surfaces and back faces of the upper and lower electrodes of the CVD chamber and the wall surface of the CVD chamber, thereby removing the by-product.

In addition, in this case, the discharge is not carried out between the RF electrode and the counter electrode. Therefore, it is possible to relieve a damage over the upper electrode and the counter electrode stage.

In the present invention, moreover, it is desirable that the second frequency should be 60 MHz and the first frequency should be 13.56 MHz.

By such a structure, when the deposited film is to be formed on the surface of the substrate and the cleaning gas is to be then introduced to carry out the plasma cleaning over the inside of the CVD chamber, the RF having a comparatively low frequency of 13.56 MHz as the first frequency is applied to the RF electrode at the first step. Consequently, a plasma having a high density is generated on the condition that a small damage is caused over the counter electrode stage. Thus, it is possible to remove most of the by-product such as SiO₂ or Si₃N₄ which is stuck and deposited onto the surface of the internal wall, the electrode or the like in the CVD chamber in the film forming process.

After most of the by-product is removed at the first step, the RF having a comparatively high frequency of 60 MHz as the second frequency is applied to the RF electrode at the second step. Consequently, it is possible to completely remove the residual by-product which is stuck.

Moreover, the present invention is characterized in that a mixed gas of COF₂ and O₂ is used as the cleaning gas.

By using the mixed gas of COF₂ and O₂ as the cleaning gas, thus, it is possible to reduce the corrosion of the CVD apparatus, and furthermore, to minimize the generation of a warming gas in an exhaust gas generated by the plasma cleaning.

Furthermore, the present invention is characterized in that an F₂ gas, a mixed gas of F₂ and O₂, a mixed gas of F₂ and Ar or a mixed gas of F₂ and N₂ is used as the cleaning gas.

By using the F₂ gas, the mixed gas of F₂ and O₂, the mixed gas of F₂ and Ar or the mixed gas of F₂ and N₂ as the cleaning gas, thus, it is possible to reduce the corrosion of the CVD apparatus, and furthermore, to extremely lessen the generation of a warming gas in an exhaust gas produced by the plasma cleaning also in a process for a liquid crystal which dislikes the mixture of carbon.

In addition, the present application provides a CVD apparatus having an RF electrode for applying an RF into a CVD chamber and a counter electrode stage which is opposed thereto and can mount a substrate for forming a deposited film, comprising:
a Fourier Transform Infrared Spectrometry (FTIR) for analyzing an exhaust gas component which is provided on a gas exhaust path for discharging an exhaust gas from the CVD chamber; and
a film forming condition control device,
wherein the film forming condition control device changes a film forming condition such as a temperature of the counter electrode stage, an electrode interval between the RF electrode and the counter electrode stage or the like to form a film when forming the deposited film on a surface of a base material by the CVD apparatus, and
when forming the deposited film on the surface of the base material and then introducing a cleaning gas to carry out cleaning over an inside of the CVD chamber by the CVD apparatus,
the exhaust gas component is monitored by the Fourier Transform Infrared Spectrometry (FTIR),
an amount of discharge to cause a predetermined exhaust gas component to have a predetermined concentration or less is compared to obtain an optimum film forming condition such as the temperature of the counter electrode stage, the electrode interval between the RF electrode and the counter electrode stage or the like, and
formation of a film is controlled to be executed on the optimum condition.

Moreover, the present application provides a film forming method using a CVD apparatus having an RF electrode for applying an RF into a CVD chamber and a counter electrode stage which is opposed thereto and can mount a substrate for forming a deposited film, comprising:
a Fourier Transform Infrared Spectrometry (FTIR) for analyzing an exhaust gas component which is provided on a gas exhaust path for discharging an exhaust gas from the CVD chamber; and
a film forming condition control device,
wherein the film forming condition control device changes a film forming condition such as a temperature of the counter electrode stage, an electrode interval between the RF electrode and the counter electrode stage or the like to form a film when forming the deposited film on a surface of a base material by the CVD apparatus, and
when forming the deposited film on the surface of the base material and then introducing a cleaning gas to carry out cleaning over an inside of the CVD chamber by the CVD apparatus,
the exhaust gas component is monitored by the Fourier Transform Infrared Spectrometry (FTIR),
an amount of discharge to cause a predetermined exhaust gas component to have a predetermined concentration or less is compared to obtain an optimum film forming condition such as the temperature of the counter electrode stage, the electrode interval between the RF electrode and the counter electrode stage or the like, and
formation of a film is executed on the optimum condition.

By such a structure, for example, in the case in which an SiO₂ film is formed, it is discharged as SiF₄ in the cleaning. Therefore, the amount of the discharge of SiF₄ which is monitored by the Fourier Transform Infrared Spectrometry (FTIR) can be regarded as the amount of a film to be the by-product stuck into the CVD chamber.

Accordingly, the film is formed by changing the film forming condition such as the temperature of the counter electrode stage or the electrode interval between the RF electrode and the counter electrode stage in the film formation, for example. In the execution of the cleaning, the exhaust gas component is monitored by the Fourier Transform Infrared Spectrometry (FTIR) to compare the amount of the discharge obtained until the predetermined exhaust gas component has a predetermined concentration or less, for example, the amount of the discharge of SiF₄ exceeds 100 ppm, the cleaning progresses and the same amount reaches 100 ppm or less again. Thus, it is possible to obtain an optimum film forming condition that the amount of the by-product which is stuck and deposited is reduced.

By executing the formation of a film on the optimum condition, it is possible to reduce the amount of the by-product such as SiO₂ or Si₃N₄ which is stuck and deposited onto the surface of the internal wall, the electrode or the like in the CVD chamber in the film forming process. As a result, it is possible to shorten a time required for the cleaning in the cleaning and to reduce the amount of the discharge of a gas having a high global warming coefficient.

In the present invention, furthermore, it is desirable that the temperature of the counter electrode stage on the optimum condition should be 250 to 400°C, preferably 350°C.

By setting the temperature of the counter electrode stage to be such a temperature, there is extremely reduced the amount of the by-product such as SiO₂, Si₃N₄ or the like which is stuck and deposited onto the surface of the internal wall, the electrode or the like in the CVD chamber in the film forming process.

In the present invention, moreover, it is desirable that the electrode interval between the RF electrode and the counter electrode stage on the optimum condition should be 8 to 30 mm, and preferably, 17 mm.

By setting the electrode interval between the RF electrode and the counter electrode stage to have a such a size, there is extremely reduced the amount of the by-product such as SiO₂, Si₃N₄ or the like which is stuck and deposited onto the surface of the internal wall, the electrode or the like in the CVD chamber in the film forming process.

### BRIEF DESCRIPTION OF THE DRAWINGS

Fig. 1 is a schematic view showing an example of a CVD apparatus according to the present invention.
Fig. 2 is a schematic view showing another example of the CVD apparatus according to the present invention.
Fig. 3 is a schematic view showing yet another example of the CVD apparatus according to the present invention.
Fig. 4 is a schematic view showing a further example of the CVD apparatus according to the present invention.
Fig. 5 is a graph showing a relationship between a time and a concentration (the concentration of SiF₄).
Fig. 6 is a graph showing a relationship between a lower electrode temperature and an electrode interval, and the amount of discharge of SiF₄.
Fig. 7 is a graph showing a corroded layer depth (a damage depth) in the case in which a high frequency of 60 MHz is applied by using a mixed gas of C₂F₆ and O₂.
Fig. 8 is a graph showing a corroded layer depth (a damage depth) in the case in which a high frequency of 13.56 MHz is applied by using the mixed gas of C₂F₆ and O₂.
Fig. 9 is a graph showing a corroded layer depth (a damage depth) in the case in which the high frequency of 60 MHz is applied by using a mixed gas of COF₂ and O₂.
Fig. 10 is a graph showing a corroded layer depth (a damage depth) in the case in which the high frequency of 13.56 MHz is applied by using the mixed gas of COF₂ and O₂.
Fig. 11 is a schematic view showing a plasma CVD apparatus to be used in a conventional plasma CVD method.
Fig. 12 is a schematic view showing the state of a by-product stuck and deposited into a CVD chamber in the plasma CVD apparatus to be used in the conventional plasma CVD method.

### BEST MODE FOR CARRYING OUT THE INVENTION

An embodiment (example) of the present invention will be described below in more detail with reference to the drawings.

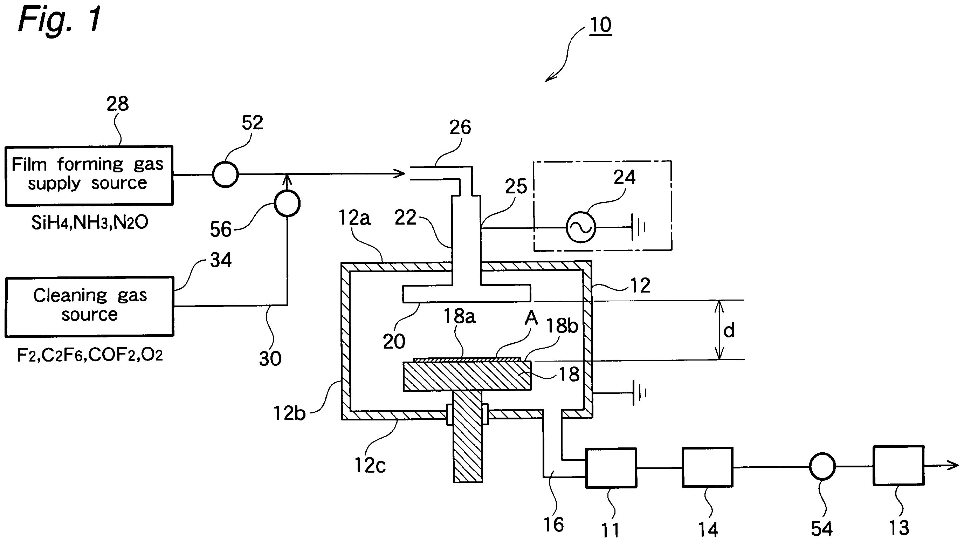

Fig. 1 is a schematic view showing an example of a CVD apparatus according to the present invention.

As shown in Fig. 1, a plasma CVD apparatus 10 to be used in a plasma CVD method comprises a CVD chamber 12 maintained in a pressure reducing state (a vacuum state), and is maintained in a constant vacuum state (a pressure reducing state) by discharging an internal gas to an outside by means of a mechanical booster pump 11, a dry pump 14 and a harm removing device 13 for causing an exhaust gas to be non-toxic through an exhaust path 16 formed on a bottom wall 12c of the CVD chamber 12.

Moreover, a lower electrode 18 constituting a stage (a counter electrode stage) for mounting a base material A to accumulate (containing deposition) a thin silicon film on the surface of a silicon wafer or the like is provided in the CVD chamber 12, for example. The lower electrode 18 penetrates through the bottom wall 12c of the CVD chamber 12 and is constituted to be vertically slidable by a driving mechanism which is not shown, and a position can be thus adjusted. A seal member such as a seal ring is provided in a sliding portion between the lower electrode 18 and the bottom wall 12c in order to ensure a degree of vacuum in the CVD chamber 12, which is not shown.

On the other hand, an upper electrode 20 to be an RF electrode constituting a reactive gas introducing device is provided in the upper part of the CVD chamber 12, and a base end portion 22 thereof penetrates through a top wall 12a of the CVD chamber 12 and is connected to a high frequency power supply 24 provided on the outside of the CVD chamber 12. The upper electrode 20 is provided with a high frequency applying device 25 such as a high frequency applying coil which is not shown, and a matching circuit which is not shown is provided between the high frequency applying device 25 and the high frequency power supply 24. Consequently, a high frequency generated by the high frequency power supply 24 can be propagated to the high frequency applying device 25 such as the high frequency applying coil without a loss.

Moreover, a reactive gas supply path 26 is formed on the upper electrode 20, and a film forming gas is introduced from a film forming gas supply source 28 through the reactive gas supply path 26 and the upper electrode 20 into the CVD chamber 12 maintained in the pressure reducing state.

Furthermore, a cleaning gas supply path 30 branches and is connected to the reactive gas supply path 26 and a cleaning gas supplied from a cleaning gas source 34 can be thus introduced into the CVD chamber 12 through the cleaning gas supply path 30.

In the drawings, 52, 54 and 56 denote switching valves.

The CVD apparatus 10 according to the present invention which is thus constituted is operated in the following manner.

First of all, the base material A for depositing a thin silicon film on the surface of a silicon wafer or the like is mounted on the stage of the lower electrode 18 of the CVD chamber 12, for example, and a distance from the upper electrode 20 is adjusted to be a predetermined distance by means of a driving mechanism which is not shown.

Then, an internal gas is discharged through the dry pump 14 to an outside via the exhaust path 16 formed on the bottom wall 12c of the CVD chamber 12, thereby maintaining a constant vacuumstate (a pressure reducing state), for example, a pressure reducing state of 10 to 2000 Pa.

Thereafter, the switching valve 52 provided on the reactive gas supply path 26 is opened so that the film forming gas is introduced from the film forming gas supply source 28 through the reactive gas supply path 26 and the upper electrode 20 into the CVD chamber 12 maintained in the pressure reducing state.

In this case, the switching valve 52 provided on the reactive gas supply path 26 and the switching valve 54 provided on the exhaust path 16 are opened, and the switching valve 56 provided on the cleaning gas supply path 30 is closed.

In this case, it is preferable to supplymonosilane (SiH₄), N₂O, N₂, O₂, Ar and the like in the formation of the film of silicon oxide (SiO₂) and monosilane (SiH₄), NH₃, N₂ O₂ and Ar in the formation of the film of silicon nitride (Si₃N₄ or the like) as a film forming gas to be supplied from the film forming gas supply source 28. However, the film forming gas is not restricted thereto but a proper change can be carried out, that is, it is possible to use disilane (Si₂H₆), TEOS (tetraethoxysilane ; Si(OC₂H₅)₄) or the like for the film forming gas and O₂, O₃ or the like for a carrier gas depending on the type of a thin film to be formed.

A high frequency is generated from the high frequency power supply 24 and a high frequency electric field is generated on the upper electrode 20 from the high frequency applying device 25 such as the high frequency applying coil, and an electron is caused to collide with the neutral molecule of the film forming gas in the electric field so that a high frequency plasma is formed and the film forming gas is thus decomposed into an ion and a radical. By the action of the ion and the radical, a thin silicon film is formed on the surface of the base material A such as a silicon wafer which is provided on the lower electrode 18.

In such a CVD apparatus 10, in the film forming process, a thin film material such as SiO₂ or Si₃N₄ is stuck and deposited onto the surface of an internal wall, an electrode or the like in the CVD chamber 12 other than the base material A to form a film by a discharge in the CVD chamber 12 so that a by-product is formed. When the by-product grows to have a constant thickness, it is peeled and scattered by a dead weight, a stress or the like. In the film forming process, consequently, particulates are mixed as foreign matters into a semiconductor product and a contamination is caused so that a thin film of high quality cannot be manufactured. Thus, the disconnection or short circuit of a semiconductor circuit is caused, and furthermore, a yield or the like might be reduced.

For this reason, in the CVD apparatus 10 according to the present invention, a fluorine type cleaning gas having a fluorine containing compound, that is, a cleaning gas supplied from the cleaning gas source 34 is introduced into the CVD chamber 12 through the cleaning gas supply path 30.

More specifically, after the thin film process is ended as described above, the switching valve 52 provided on the reactive gas supply path 26 is closed to stop the supply of the film forming gas from the film forming gas supply source 28 into the CVD chamber 12.

Then, the switching valve 56 provided on the cleaning gas supply path 30 is opened to introduce the cleaning gas from the cleaning gas source 34 into the CVD chamber 12 through the cleaning gas supply path 30.

Thereafter, a high frequency is generated from the high frequency power supply 24 and a high frequency electric field is generated on the upper electrode 20 from the high frequency applying device 25 such as a high frequency applying coil so that a high frequency plasma is formed and the cleaning gas is thus decomposed into an ion and a radical. Consequently, the ion or the radical reacts to a by-product such as SiO₂ or Si₃N₄ which is stuck and deposited onto the surface of an internal wall, an electrode or the like in the CVD chamber 12 so that the by-product is changed into a gas as SiF₄.

Subsequently, the by-product changed into the gas discharges an internal gas to an outside by means of the mechanical booster pump 11, the dry pump 14 and the harm removing device 13 for causing an exhaust gas to be non-toxic through the exhaust path 16 formed on the bottom wall 12c of the CVD chamber 12.

In this case, it is possible to carry out switching into a first frequency to be applied for forming a film and a second frequency to be applied for carrying out the plasma cleaning.

By such a structure, an RF frequency to be applied to the RF electrode can be switched into the first frequency to be applied for forming a film and the second frequency to be applied for carrying out the plasma cleaning. By using the first frequency, therefore, it is possible to generate a plasma having a high density on a suitable condition for forming a film. Thus, it is possible to manufacture a thin film of high quality.

In addition, the switching to the second frequency is carried out when the plasma cleaning is to be performed. Consequently, a plasma having a high density can be generated on a suitable condition for the plasma cleaning. Thus, it is possible to efficiently remove a by-product such as SiO₂ or Si₃N₄ which is stuck and deposited onto the surface of the internal wall, the electrode or the like in the CVD chamber in the film forming process.

In this case, furthermore, it is desirable to have a first step of applying an RF having the first frequency to the RF electrode to carry out the plasma cleaning and a second step of then applying an RF having the second frequency to carry out the plasma cleaning in the execution of the plasma cleaning. More specifically, in this case, it is desirable that a power having a high frequency of 13.56 MHz should be set to be the first frequency to be applied in the execution of the plasma cleaning and 60 MHz should be set to be the second frequency to be applied in the execution of the plasma cleaning.

By such a structure, when the cleaning gas is to be introduced to carry out the plasma cleaning over the inside of the CVD chamber after a deposited film is formed on the surface of a substrate, an RF of 13.56 MHz to be a comparatively low frequency as the first frequency is applied to the RF electrode at the first step, for example. In this case, the deposited film is left on the counter electrode, the internal wall of the CVD chamber and the like. For this reason, it is possible to generate a plasma having a high density, thereby removing most of a by-product such as SiO₂ or Si₃N₄ which is stuck and deposited onto the surface of the internal wall, the electrode or the like in the CVD chamber in the film forming process on a condition that the counter electrode stage or the like is less damaged.

After most of the by-product is removed at the first step, then, an RF of 60 MHz to be a comparatively high frequency as the second frequency is applied to the RF electrode at the second step, for example. Consequently, it is possible to completely remove the residual by-product which is stuck on a condition that a corrosion is lessened.

In addition, it is possible to relieve a damage over the upper electrode and the counter electrode stage by carrying out the plasma cleaning at the second step in a short time.

In this case, furthermore, an electrode interval between the lower electrode 18 and the upper electrode 20 is changed at the first step and the second step.

By thus changing the electrode interval at the first step and the second step to reduce a gap between the electrodes at the first step, for example, it is possible to generate a plasma having a high density and to remove the by-product stuck to the upper electrode, the counter electrode and the upper side wall of the CVD chamber.

By more increasing the gap between the electrodes at the second step than that at the first step, for example, it is possible to widely clean the side surfaces and back faces of the upper and lower electrodes of the CVD chamber and the wall surface of the CVD chamber, thereby removing the by-product.

Referring to the interval between the electrodes, an electrode interval d is preferably set to be 5 to 50 mm and more preferably 8 to 20 mm at the first step, and the electrode interval d is preferably set to be 10 to 100 mm and more preferably 20 to 60 mm at the second step.

In this case, examples of a fluorine type cleaning gas containing a fluorine compound to be used for a cleaning process include perfluorocarbons having a carbon atomic number of 1 to 6, for example:
chain aliphatic perfluorocarbons such as CF₄, C₂F₆, C₃F₈, C₄F₁₀, C₅F₁₂ and the like
alicyclic perfluorocarbons such as C₄F₈, C₅F₁₀, C₆F₁₂ and the like;
straight chain perfluoroethers such as CF₃OCF₃, CF₃OC₂F₅, C₂F₅OC₂F₅ and the like;
circular perfluoroethers such as C₃F₆O, C₄F₈O, C₅F₁₀O and the like;
unsaturated perfluorocarbons such as C₃F₆, C₄F₈, C₅F₁₀ and the like; and
diene type perfluorocarbons such as C₄F₆, C₅F₈ and the like.

Moreover, it is also possible to use perfluorocarbons containing oxygen such as COF₂, CF₃COF, CF₃OF and the like, and fluorine compounds containing nitrogen such as NF₃, FNO, F₃NO, FNO₂ and the like and preferably fluorine compounds containing oxygen and nitrogen, and the like.

These fluorine containing compounds may contain at least one fluorine atom having a part substituted for a hydrogen atom. It is preferable to use CF₄, C₂F₆, F₃F₈ and COF₂, and more preferable to use CF₄, C₂F₆ and COF₂.

These fluorine containing compounds can be used singly or in combination.

Moreover, the cleaning gas having the fluorine containing compound to be used in the present invention can be used by properly mixing other gases within such a range that the advantages of the present invention are not damaged. Examples of the other gases include He, Ne, Ar, O₂ and the like. The amounts of blending of the other gases are not particularly restrictedbut they canbe determined corresponding to the amount and thickness of a by-product (an adherend) stuck to the internal wall of the CVD chamber 12 in the CVD apparatus 10 or the like, the type of a fluorine containing compound to be used, the composition of the by-product and the like.

For a cleaning gas to be used for a cleaning treatment, moreover, it is possible to use a fluorine gas (F₂) in addition to a fluorine type cleaning gas containing the fluorine compound.

More specifically, an additional gas such as oxygen or argon is usually mixed in a proper amount and is thus used together with the cleaning gas in the plasma cleaning.

Referring to a mixed gas type of the cleaning gas and the additional gas, when the concentration of content of the cleaning gas is increased on a condition that the total flow of the gas is constant, an etching speed tends to be increased. However, there is a problem in that the generation of a plasma becomes unstable, the etching speed is reduced, and a cleaning uniformity is deteriorated when the concentration of the cleaning gas exceeds a constant concentration. In particular, when the cleaning gas is used in a concentration of 100%, the instability of the generation of the plasma, the reduction in the etching speed, and the deterioration in the cleaning uniformity tend to be more remarkable. Consequently, there is a problem in that a utility cannot be obtained.

For this reason, it is necessary to carry out a dilution to set the concentration of the cleaning gas to be low, that is, a concentration at the peak of an etching speed - cleaning gas concentration curve or less for use. In order to suppress a reduction in the etching speed which is caused by the dilution, a chamber pressure in the cleaning is raised or a gas flow is increased so that the cleaning condition is optimized. When the chamber pressure in the cleaning is raised or the gas flow is increased, however, the generation of a plasma becomes unstable and the cleaning uniformity is damaged so that efficient cleaning cannot be carried out.

On the other hand, when the fluorine gas or the mixed gas of the fluorine gas and a gas which does not substantially react to fluorine in the plasma is used as the cleaning gas, the plasma treatment can be carried out so that a very high etching speed can be obtained. In addition, the plasma can be generated stably on the condition that a total gas flow is set to be approximately 1000 sccm and a chamber pressure is set to be approximately 400 Pa, and furthermore, an excellent cleaning uniformity can be ensured.

It is desirable that the fluorine gas to be used as the cleaning gas should have 100% by volume and should generate a plasma by a discharge.

Moreover, the cleaning gas may be constituted by a fluorine gas for generating a plasma by a discharge and a gas which does not substantially react to fluorine in the plasma.

In this case, it is preferable that the concentration of the fluorine gas for generating the plasma by the discharge should be higher than 20% by volume and lower than 100% by volume, and the concentration of a gas which does not substantially react to the fluorine in the plasma should be higher than 0% by volume and equal to or lower than 80% by volume (the fluorine gas for generating the plasma by the discharge + the gas which does not substantially react to the fluorine = 100% by volume) .

Moreover, it is more preferable that the concentration of the fluorine gas for generating the plasma by the discharge should be higher than 30% by volume and lower than 100% by volume, and the concentration of a gas which does not substantially react to the fluorine in the plasma should be higher than 0% by volume and equal to or lower than 70% by volume (the fluorine gas for generating the plasma by the discharge + the gas which does not substantially react to the fluorine = 100% by volume) .

Furthermore, it is preferable that the gas which does not substantially react to the fluorine in the plasma should be at least one selected from a group consisting of nitrogen, oxygen, carbon dioxide, N₂O, dry air, argon, helium and neon.

In this case, the "fluorine" in the gas which does not substantially react to the fluorine contains a fluorine molecule, a fluorine atom, a fluorine radical, a fluorine ion and the like.

Examples of a target compound for chamber cleaning by the fluorine type compound include an adherend consisting of a silicon type compound which is stuck to a CVD chamber wall, the jig of a CVD apparatus or the like through a CVD method or the like. Referring to the adherend of the silicon type compound, at least one of the following compounds can be taken as an example:
(1) a compound consisting of silicon;
(2) a compound consisting of at least one of oxygen, nitrogen, fluorine and carbon, and silicon; and
(3) a compound consisting of a high-melting metal silicide. More specifically, examples include high-melding metal silicides such as Si, SiO₂, Si₃N₄ and WSi.

In consideration of advantages obtained by cleaning the by-product stuck to the internal wall of the chamber 12, moreover, it is desirable that the flow of the introduction of the cleaning gas into the CVD chamber 12 should be 0.1 to 10 L/minute, and preferably, 0.5 to 1 L/minute. More specifically, if the flow of the introduction of the cleaning gas into the CVD chamber 12 is smaller than 0.1 L/minute, the cleaning advantages cannot be expected. To the contrary, if the flow of the introduction is greater than 10 L/minute, the amount of the cleaning gas discharged to the outside is increased without contributing to the cleaning.

The flow of the introduction can be properly changed depending on the type and size of the base material A and the like, for example, a flat panel disk. As an example, if the fluorine containing compound is C₂F₆, it is preferable to set 0.5 to 5 L/minute.

In consideration of advantages obtained by cleaning the by-product stuck to the internal wall of the chamber 12, furthermore, it is desirable that the pressure of the cleaning gas in the CVD chamber 12 should be 10 to 2000 Pa, and preferably, 50 to 500 Pa. More specifically, if the pressure of the cleaning gas in the CVD chamber 12 is lower than 10 Pa or is higher than 2000 Pa, the cleaning advantages cannot be expected. The pressure in the CVD chamber 12 can be properly changed depending on the type and size of the base material A and the like, for example, a flat panel disk. As an example, if the fluorine containing compound is C₂F₆, it is preferable to set 100 to 500 Pa.

In this case, it is suitable that a mixed gas of COF₂ and O₂ should be used as the cleaning gas.

By using the mixed gas of COF₂ and O₂ as the cleaning gas, more specifically, it is possible to reduce the corrosion of the CVD apparatus and to minimize the generation of a warming gas in an exhaust gas generated by the plasma cleaning.

Referring to the mixed gas of COF₂ and O₂, it is desirable that the cleaning should be carried out by a mixed gas containing 50% to 98% of COF₂ with a total molarity of 100% as a first cleaning gas in the first step and the cleaning should be carried out by a mixed gas containing 40% to 90% of COF₂ with a total molarity of 100% as a second cleaning gas in the second step, for example.

In this case, furthermore, it is suitable that an F₂ gas, a mixed gas of F₂ and O₂, a mixed gas of F₂ and Ar or a mixed gas of F₂ and N₂ should be used as the cleaning gas.

By using, as the cleaning gas, the F₂ gas, the mixed gas of F₂ and O₂, the mixed gas of F₂ and Ar or the mixed gas of F₂ and N₂, more specifically, it is possible to reduce the corrosion of the CVD apparatus, and furthermore, to extremely lessen the generation of a warming gas in an exhaust gas produced by the plasma cleaning also in a process for a liquid crystal which dislikes the mixture of carbon.

In this case, referring to the mixed gas of F₂ and Ar, it is desirable that the cleaning should be carried out by a mixed gas containing 30% to 100% of F₂ with a total molarity of 100% as a first cleaning gas in the first step and the cleaning should be carried out by a mixed gas containing 20% to 100% of F₂ with a total molarity of 100% as a second cleaning gas in the second step, for example.

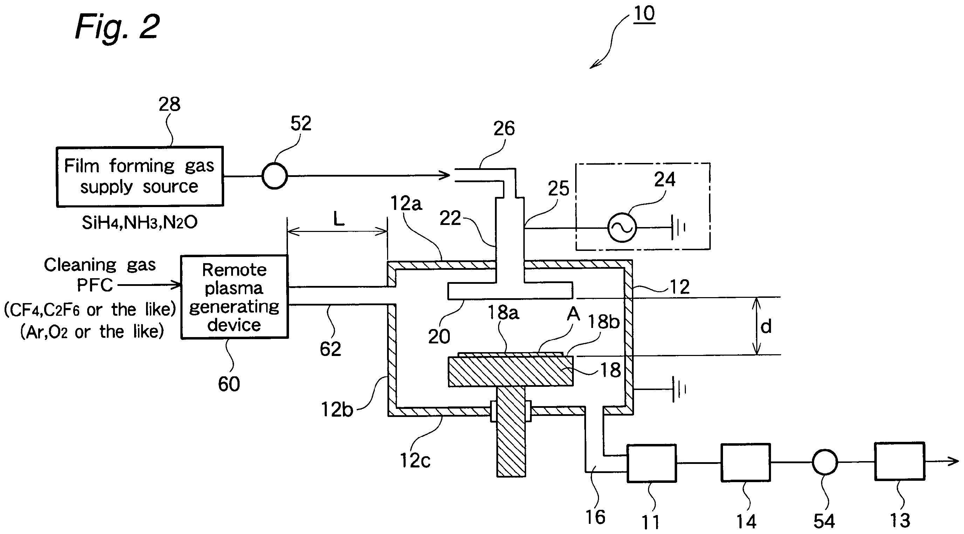

Fig. 2 is a schematic view showing another example of the CVD apparatus according to the present invention.

A CVD apparatus 10 according to the present example has basically the same structure as that of the CVD apparatus 10 shown in Fig. 1, and the same components have the same reference numerals and detailed description thereof will be omitted.

In the CVD apparatus 10 according to the present example, a remote plasma generating device 60 for changing a fluorine type cleaning gas having a fluorine containing compound into a plasma is further provided in the side portion of a CVD chamber 12.

Then, the cleaning gas changed into the plasma by the remote plasma generating device 60 is introduced into a side wall 12b of the CVD chamber 12 through a connecting piping 62 constituting a gas introducing path.

More specifically, in the plasma CVD apparatus 10 according to the present example, a fluorine type cleaning gas having a fluorine containing compound is changed into a plasma by the remote plasma generating device 60, and is introduced through the connecting piping 62 into the CVD chamber 12 maintained in a pressure reducing state.

In the remote plasma generating device 60, a high frequency plasma is formed so that the cleaning gas is decomposed into an ion and a radical, and the ion and the radical react to a by-product such as SiO₂ or Si₃N₄ which is stuck and deposited onto the surface of an internal wall, an electrode or the like in the CVD chamber 12. Consequently, the by-product is changed into a gas as SiF₄ and is thus discharged together with an exhaust gas to the outside of the CVD chamber 12 through an exhaust path 16 by means of a pump 14.

In this case, it is desirable to have a first step of applying a high frequency from a high frequency applying device 25 to an upper electrode 20, thereby carrying out plasma cleaning and a second step of then introducing a cleaning gas activated by the remote plasma generating device 60 into the side surfaces and back faces of the upper and lower electrodes of the CVD chamber 12 and the wall surface of the CVD chamber 12, thereby carrying out the cleaning.

By such a structure, the plasma cleaning is carried out by using a parallel plate electrode at the first step. Therefore, it is possible to remove the by-product stuck to the upper electrode 20, a counter electrode 18 and the upper side wall of the CVD chamber 12.

At the second step, then, the cleaning gas activated by the remote plasma generating device 60 is introduced into the side surfaces and back faces of the upper and lower electrodes of the CVD chamber 12 and the wall surface of the CVD chamber 12. Consequently, the dissociation efficiency of the cleaning gas can be enhanced and the by-product such as SiO₂ or Si₃N₄ which is stuck to the side surfaces and back faces of the upper and lower electrodes of the CVD chamber 12 and the wall surface of the CVD chamber 12 can be removed efficiently.

In addition, in the plasma cleaning at the second step, the cleaning gas activated by the remote plasma is introduced into the CVD chamber. For this reason, the plasma is not excited between the upper electrode 20 and the counter electrode 18 and it is possible to relieve a damage over the upper electrode and the counter electrode.

In this case, it is desirable that a distance between the remote plasma generating device 60 and the CVD chamber 12, that is, a length L of the connecting piping 62 should be 0 to 200 cm, preferably, 0 to 100 cm, and further preferably, 0 to 50 cm. More specifically, if the length L is greater than 200 cm, the cleaning gas changed into a plasma comes in contact and collides with the wall portion of the connecting piping 62. Consequently, an efficiency for changing the by-product into a gas is reduced. The length L is preferred to be shorter and is desirably determined properly depending on the type and size of a base material A or the like.

In this case, the material of the connecting piping 62 is not particularly restricted but it is desirably constituted by alumina, passivated aluminum, a fluorine type resin, a metal coated with the fluorine type resin and the like, for example, in consideration of the advantage of preventing the reduction in a gasification efficiency.

While the remote plasma generating device 60 and the CVD chamber 12 are set to introduce the cleaning gas changed into a plasma from the chamber side wall 12b through the connecting piping 62 in the present example, moreover, this is not restricted but the cleaning gas is preferably introduced directly into the CVD chamber 12 and may be introduced from a top wall 12a and a bottom wall 12c of the CVD chamber 12 to directly clean the chamber wall surface, for example.

While a well-known remote plasma generating device is preferably used for the remote plasma generating device 60 and is not particularly restricted, it is possible to use "ASTRON" (manufactured by ASTEX Co., Ltd.) as an example.

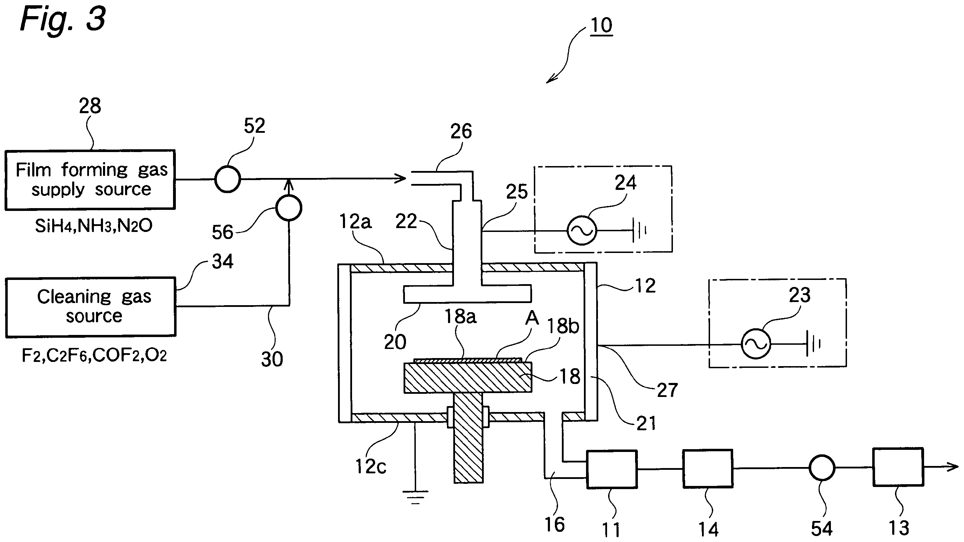

Fig. 3 is a schematic view showing yet another example of the CVD apparatus according to the present invention.

A CVD apparatus 10 according to the present example has basically the same structure as that of the CVD apparatus 10 shown in Fig. 1, and the same components have the same reference numerals and detailed description thereof will be omitted.

In the CVD apparatus 10 according to the present example, a second RF electrode 21 is provided on a side wall 12b of a CVD chamber 12 separately from an upper electrode 20.

The second RF electrode 21 is connected to a high frequency power supply 23. The second RF electrode 21 is provided with a high frequency applying device 27 such as a high frequency applying coil, which is not shown, and a matching circuit which is not shown is provided between the high frequency applying device 27 and the high frequency power supply 23.

In this case, it is desirable to have a first step of applying an RF to the upper electrode 20 to carry out plasma cleaning, and a second step of then applying the RF to the second RF electrode 21 provided separately from the upper electrode 20 and carrying out a discharge, thereby performing the plasma cleaning over the side surfaces and back faces of the upper electrode 20 and a counter electrode stage 18 and the side wall of the CVD chamber 12.

By such a structure, at the first step, it is possible to mainly remove the by-product stuck to the upper electrode, the counter electrode and the upper side wall of the CVD chamber.

At the second step, then, the RF is applied to the second RF electrode provided on the side wall of the CVD chamber, for example, separately from the upper electrode and is thus discharged. Consequently, it is possible to carry out the plasma cleaning over the side surfaces and back faces of the upper electrode and the counter electrode stage and the side wall of the CVD chamber.

In addition, in this case, the discharge is not carried out between the RF electrode and the counter electrode. Therefore, it is possible to relieve a damage over the upper electrode and the counter electrode stage without the excitation of a plasma between the upper electrode and the counter electrode.

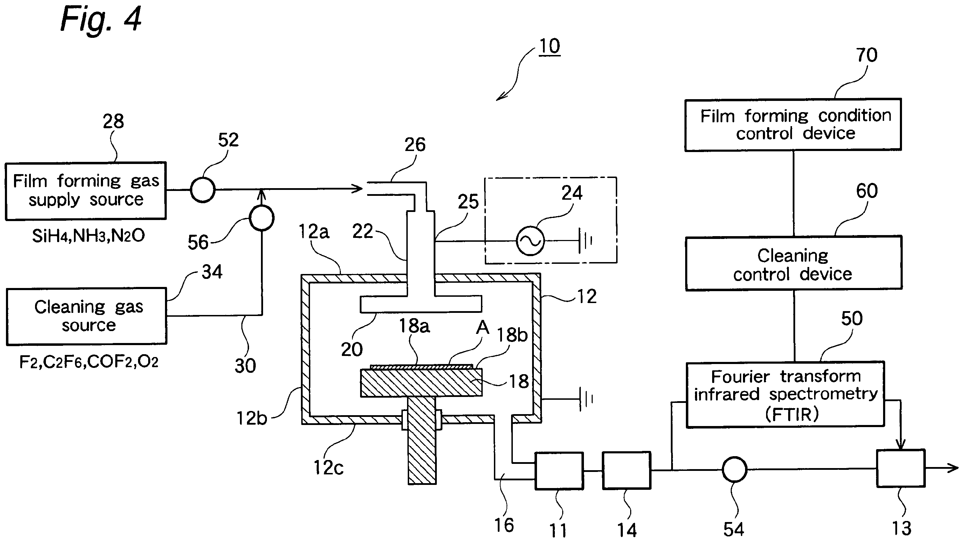

Fig. 4 is a schematic view showing a further example of the CVD apparatus according to the present invention.

A CVD apparatus 10 according to the present example has basically the same structure as that of the CVD apparatus 10 shown in Fig. 1, and the same components have the same reference numerals and detailed description thereof will be omitted.

In the CVD apparatus 10 according to the present example, as shown in Fig. 4, an exhaust path 16 to be a gas exhaust path is provided with a Fourier Transform Infrared Spectrometry (FTIR) 50 for analyzing an exhaust gas component between a dry pump 14 and a harm removing device 13 at the downstream side of the dry pump 14.

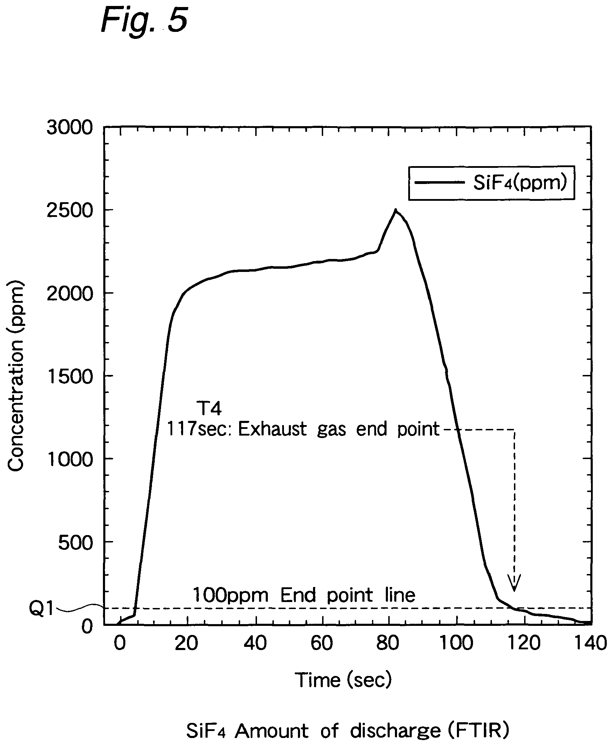

More specifically, as shown in a graph of a time - concentration (the concentration of SiF₄) in Fig. 5, the concentration of SiF₄ in an exhaust gas from a CVD chamber 12 is equal to or lower than a constant level Q1 at a predetermined time T4.

Accordingly, the concentration data of SiF₄ in the exhaust gas from the CVD chamber 12 are monitored by the Fourier Transform Infrared Spectrometry 50 and are compared with the prestored concentration data of SiF₄ in a cleaning control device 60, and a control is carried out to end the cleaning at the time T4 that a predetermined cleaning end point concentration Q1 is reached.

By such a structure, the concentration of the gasified SiF₄ generated by reacting to a by-product such as SiO₂ or Si₃N₄ which is stuck and deposited onto the surface of an internal wall, an electrode or the like in the CVD chamber 12, the piping of a gas exhaust path and the like is directly monitored in the cleaning. Consequently, the cleaning can be ended at a time that the cleaning is to be completed accurately.

In this case, it is desirable that a cleaning end point concentration should be 100 ppm depending on the size of the CVD chamber 12 in the CVD apparatus 10 in order to completely remove the by-product such as SiO₂ or Si₃N₄ which is stuck and deposited onto the surface of the internal wall, the electrode or the like in the CVD chamber 12, the piping of the gas exhaust path and the like.

If the cleaning end point concentration is 100 ppm, consequently, the concentration of SiF₄ in the exhaust gas fed from the CVD chamber 12 corresponds to a concentration capable of completely removing the by-product such as SiO₂ or Si₃N₄ which is stuck and deposited onto the piping of the gas exhaust path and the like in addition to the surface of the internal wall, the electrode or the like in the CVD chamber 12.

Accordingly, the cleaning is ended in the cleaning end point concentration of 100 ppm. Consequently, the cleaning can be ended at the time T4 (after 117 seconds in the present example) that the cleaning is to be completed accurately. As a result, the by-product can be removed completely.

The Fourier Transform Infrared Spectrometry (FTIR) 50 is not particularly restricted but "GMS-1000" manufactured by MIDAC Co., Ltd. or the like can be used, for example.

By such a structure, for example, in the case in which an SiO₂ film is formed, it is discharged as SiF₄ in the cleaning. Therefore, the amount of the discharge of SiF₄ which is monitored by the Fourier Transform Infrared Spectrometry (FTIR) 50 can be regarded as the amount of a film to be the by-product stuck into the CVD chamber 12.

Accordingly, the film is formed by changing a film forming condition such as the temperature of a counter electrode stage 18 or the electrode interval between an RF electrode 20 and the counter electrode stage 18 in the film formation, for example . In the execution of the cleaning, the exhaust gas component is monitored by the Fourier Transform Infrared Spectrometry (FTIR) 50 to compare the amounts of the discharge obtained until the predetermined exhaust gas component has a predetermined concentration or less, for example, the amount of the discharge of SiF₄ exceeds 100 ppm, the cleaning progresses and the amount of the discharge reaches 100 ppm or less again. Thus, it is possible to obtain an optimum film forming condition that the amount of the by-product which is stuck and deposited is reduced.

The optimum condition data in the cleaning control device 60 are input to a film forming condition control device 70 as shown in Fig. 4, and the formation of the film is executed on the optimum condition by the control of the film forming condition control device 70.

Consequently, it is possible to reduce the amount of the by-product such as SiO₂ or Si₃N₄ which is stuck and deposited onto the surface of the internal wall, the electrode or the like in the CVD chamber 12 in the film forming process. As a result, it is possible to shorten a time required for the cleaning in the cleaning and to reduce the amount of the discharge of a gas having a high global warming coefficient.

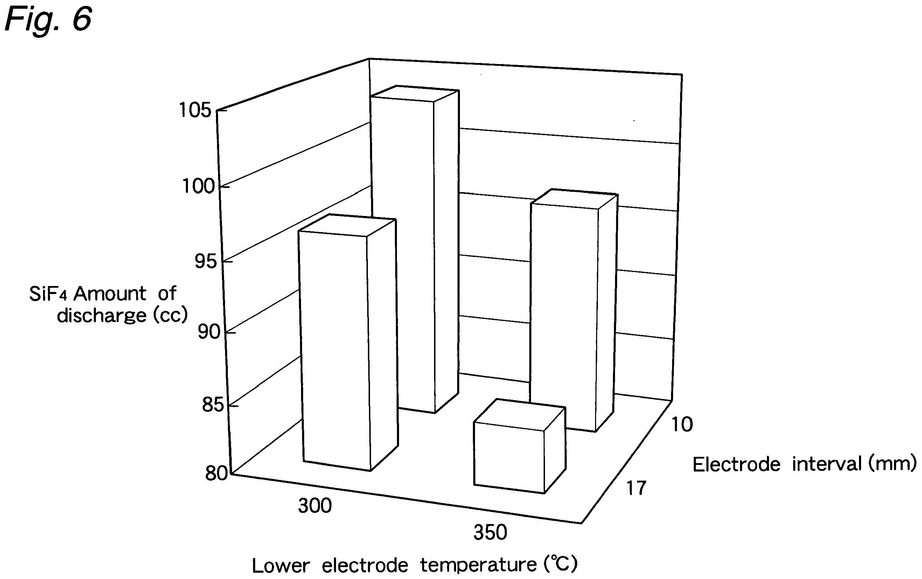

As shown in a graph of Fig. 6, moreover, it is desirable that the temperature of the counter electrode stage 18 on the optimum condition should be 250 to 400°C, and preferably, 350°C.

By setting the temperature of the counter electrode stage 18 to be such a temperature, there is extremely reduced the amount of the by-product such as SiO₂ or Si₃N₄ which is stuck and deposited onto the surface of the internal wall, the electrode or the like in the CVD chamber 12 in the film forming process.

As shown in the graph of Fig. 6, furthermore, it is desirable that an electrode interval between the RF electrode 20 and the counter electrode stage 18 on the optimum condition should be 8 to 30 mm, and preferably, 17 mm.

By setting the electrode interval between the RF electrode 20 and the counter electrode stage 18 to have such a size, there is extremely reduced the amount of the by-product such as SiO₂ or Si₃N₄ which is stuck and deposited onto the surface of the internal wall, the electrode or the like in the CVD chamber 12 in the film forming process.

The film forming condition is not restricted to the temperature of the counter electrode stage 18, the electrode interval between the RF electrode 20 and the counter electrode stage 18 and the like but includes a gas flow, a pressure, an RF Power, an RF frequency and the like as these parameters.

### EXAMPLE

### Example 1

By utilizing the CVD apparatus having the structure shown in Fig. 1, a cleaning damage was measured by using a mixed gas of C₂F₆ and O₂ (No. 1, No. 2) or a mixed gas of COF₂ and O₂ (No. 3, No. 4) as a cleaning gas on a condition shown in the following Table 1. Thus, the advantages of RF frequencies (13.56 MHz, 60 MHz) were compared with each other.

As an evaluating method, a sputter time up to A 170% or more was multiplied by 13 nm/min (a sputter rate of SiO₂) to obtain a corroded layer depth for the comparison of a corroded layer by an analysis in an AES depth direction.

**Table 1**

| No. | | Gas type | | Pressure (Pa) | RF power (W) | | Gap(mm) | Processing time (min) | Cleaning |
|---|---|---|---|---|---|---|---|---|---|
| | C2F6(sccm) | COF2 (sccm) | O2 (sccm) | | 60 (MHz) | 13.56(MHz) | | | End point time (min) |
| 1 | 300 | | 200 | 200 | 1000 | | 20 | 30 | 58 |
| 2 | 300 | | 200 | 200 | | 1000 | 20 | 30 | 51.6 |
| 3 | | 600 | 300 | 300 | 1000 | | 20 | 30 | 50.5 |
| 4 | | 600 | 300 | 300 | | 1000 | 20 | 30 | 50.6 |

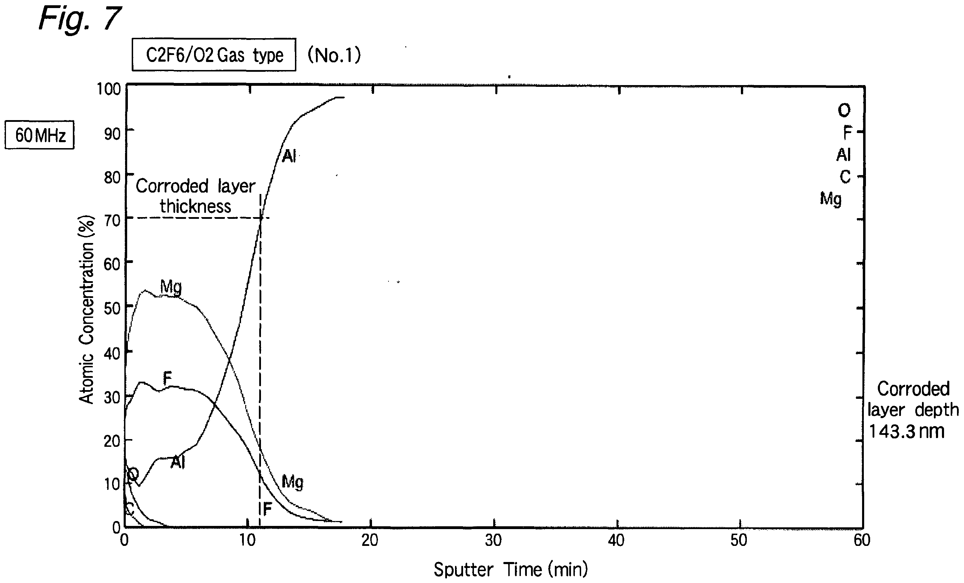

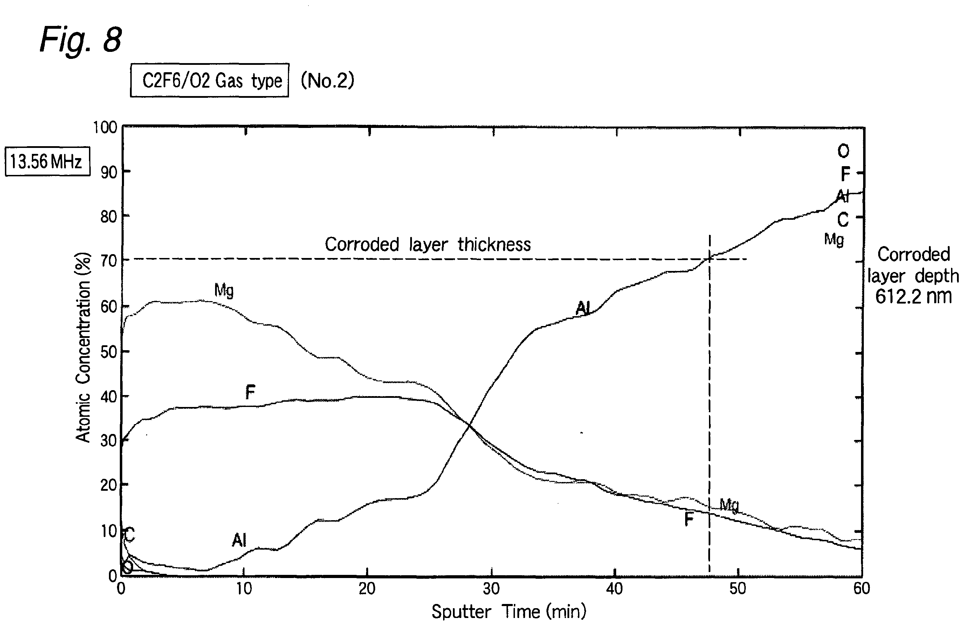

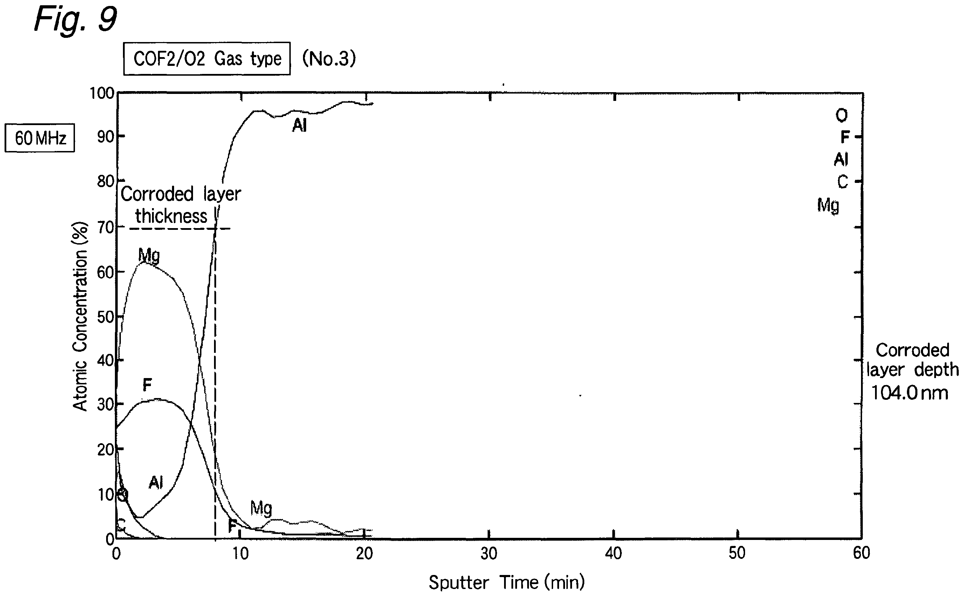

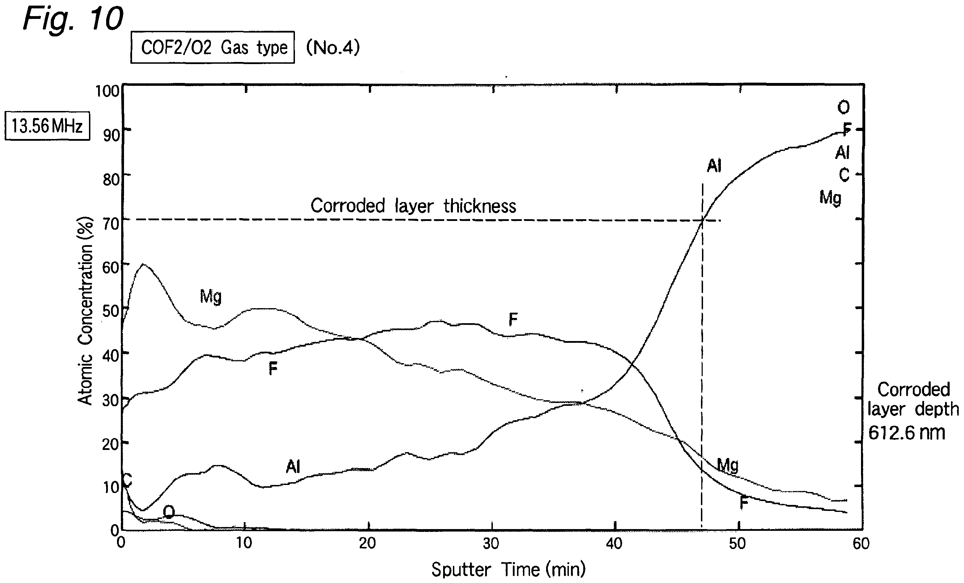

The results are shown in Fig. 7 (the mixed gas of C₂F₆ and O₂ : No. 1, 60 MHz), Fig. 8 (the mixed gas of C₂F₆ and O₂ : No. 2, 13.56 MHz), Fig. 9 (the mixed gas of COF₂ and O₂ : No. 3, 60 MHz), and Fig. 10 (the mixed gas of COF₂ and O₂ : No. 4, 13.56 MHz).

As is apparent from Figs. 8 to 10, the corroded layer depth (damage depth) is greater at 13.56 MHz than that at 60 MHz.

Accordingly, it is apparent that a by-product can be removed efficiently and a damage over the upper electrode, the counter electrode stage 18 or the like is also lessened if 13.56 MHz is used as a first frequency to remove most of the by-product and 60 MHz is then used as a second frequency.

### Example 2

By using the CVD apparatus having the structure shown in Fig. 4, a film of SiO₂ was formed on the following film forming conditions.

| | |
|---|---|
| SiH₄ | 70 sccm |
| N₂O | 2000 sccm |
| Pressure | 200Pa |
| Power supply frequency | 13.56 MHz |
| Power | 350W |

The film was formed on the assumption that each of the conditions is constant.

In this case, the film was formed with a change in a lower electrode temperature of 300°C and 350°C and an electrode interval of 10 mm and 17 mm, respectively.

After the formation of the film, the cleaning for the CVD chamber 12 was executed on the following cleaning conditions, respectively.
NF₃/Ar = 300/700 sccm
Pressure; 200 Pa
Electrode interval = 30 mm
Power = 1000 W

In this case, a gas discharged in the cleaning for the CVD chamber 12 was monitored by the Fourier Transform Infrared Spectrometry (FTIR) 50.

More specifically, in the case in which the SiO₂ film is formed, it is discharged as SiF₄ in the cleaning. Therefore, the amount of the discharge of SiF₄ which is monitored by the Fourier Transform Infrared Spectrometry (FTIR) 50 can be regarded as the amount of a film to be the by-product stuck into the CVD chamber 12.

Accordingly, the film is formed by changing the film forming condition such as the temperature of the counter electrode stage 18 or the electrode interval between the RF electrode 20 and the counter electrode stage 18 in the formation of the film as described above. In the execution of the cleaning, the exhaust gas component is monitored by the Fourier Transform Infrared Spectrometry (FTIR) 50 to compare the amounts of the discharge obtained until the predetermined exhaust gas component has a predetermined concentration or less, for example, the amount of the discharge of SiF₄ exceeds 100 ppm, the cleaning progresses and the amount of the discharge reaches 100 ppm or less again. Thus, it is possible to obtain an optimum film forming condition that the amount of the by-product which is stuck and deposited is reduced.

The results are shown in the following Table 2. Moreover, the results of the Table 2 are shown in the graph of Fig. 6. As is apparent from the graph of Fig. 6, the amount of the stuck SiO₂ is smaller if the temperature of the counter electrode stage 18 to be a lower electrode is higher, and the amount of the stuck SiO₂ is smaller if the electrode interval is greater.

As shown in the graph of Fig. 6, furthermore, it is desirable that the temperature of the counter electrode stage 18 on the optimum condition should be 250 to 400°C, and preferably, 350°C.

In addition, as shown in the graph of Fig. 6, it is desirable that the electrode interval between the RF electrode 20 and the counter electrode stage 18 on the optimum condition should be 8 to 30 mm, and preferably, 17 mm.

**Table 2**

| Electrode interval (mm) | 10 | 10 | 17 | 17 |
|---|---|---|---|---|
| Lower electrode temperature (°C) | 300 | 350 | 300 | 350 |
| Amount of discharge of SiF₄ (cc) | 103.5 | 96.7 | 96.6 | 84.5 |

The examples of the cleaning device of the plasma CVD apparatus according to the present invention have been described above. While the formation of the thin silicon film has been described for the above embodiments without departing from the scope of the present invention, for example, the present invention can also be applied to the case in which a thin film such as a silicon germanium film (SiGe), a silicon carbide film (SiC), an SiOF film, an SiON film or a carbon containing SiO₂ film is to be formed.

While the apparatus of a horizontal type has been described in the examples, the apparatus can also be replaced with an apparatus of a vertical type. Although the examples have been described for a leaf type, moreover, the present invention can also be applied to a CVD apparatus of a batch type.

While the present invention has been applied to a plasma CVD apparatus as an example in the above embodiments, furthermore, the present invention can also be applied to another CVD method such as vacuum deposition in which a thin film material is subjected to a thermal decomposition, an oxidation, a reduction, a polymerization, a vapor phase reaction or the like at a high temperature so that a thin film is deposited on a substrate. Thus, it is a matter of course that various changes can be made.

While the preferred examples according to the present invention have been described above, the present invention is not restricted thereto but various changes can be made without departing from the scope of the present invention.

### (Effect of the Invention)

According to the present invention, the frequency of the FR to be applied to the RF electrode can be switched into the first frequency to be applied for forming a film and the second frequency. By using the first frequency, therefore, a plasma having a high density can be generated on a suitable condition for forming a film and a thin film of high quality can be manufactured.

In addition, in the execution of the plasma cleaning, it is possible to generate a plasma having a high density on a suitable condition for the plasma cleaning by carrying out the switching to the second frequency. Thus, it is possible to efficiently remove a by-product such as SiO₂ or Si₃N₄ which is stuck and deposited onto the surface of an internal wall, an electrode or the like in the CVD chamber in a film forming process.

According to the present invention, moreover, when the deposited film is to be formed on the surface of the substrate and the cleaning gas is to be then introduced to carry out the plasma cleaning over the inside of the CVD chamber, the RF having a comparatively low frequency as the first frequency is applied to the RF electrode at the first step. Thus, a plasma having a high density is generated on the condition that a damage over the counter electrode stage is lessened with the deposited film left. Consequently, it is possible to remove most of the by-product such as SiO₂ or Si₃N₄ which is stuck and deposited onto the surface of the internal wall, the electrode or the like in the CVD chamber in the film forming process.

After most of the by-product is removed at the first step, the RF having a comparatively high frequency as the second frequency is applied to the RF electrode at the second step. Consequently, it is possible to completely remove the residual by-product which is stuck.

In addition, it is possible to relieve a damage over the upper electrode and the counter electrode stage by carrying out the plasma cleaning at the second step in a short time.

According to the present invention, furthermore, the electrode interval is changed at the first step and the second step. Consequently, it is possible to generate a plasma having a high density and to remove a by-product stuck to the upper electrode, the counter electrode and the upper side wall of the CVD chamber by reducing a gap between the electrodes at the first step, for example.

By more increasing the gap between the electrodes at the second step than that in the first step, for example, it is possible to carry out the cleaning over the side surfaces and back faces of the upper and lower electrodes of the CVD chamber and the wall surface of the CVD chamber, thereby removing the by-product.

According to the present invention, moreover, the plasma cleaning is carried out by using a parallel plate electrode at the first step. Therefore, it is possible to remove the by-product stuck to the upper electrode, the counter electrode and the upper side wall of the CVD chamber.

At the second step, then, the cleaning gas activated by a remote plasma is introduced into the side surfaces and back faces of the upper and lower electrodes of the CVD chamber and the wall surface of the CVD chamber. Consequently, the dissociation efficiency of the cleaning gas can be enhanced and the by-product such as SiO₂ or Si₃N₄ which is stuck to the side surfaces and back faces of the upper and lower electrodes of the CVD chamber and the wall surface of the CVD chamber can be removed efficiently.

In addition, in the plasma cleaning at the second step, the cleaning gas activated by the remote plasma is introduced into the CVD chamber and the plasma is not excited between the upper electrode and the counter electrode. Therefore, it is possible to relieve a damage over the upper electrode and the counter electrode stage.

According to the present invention, furthermore, at the first step, it is possible to mainly remove the by-product stuck to the upper electrode, the counter electrode and the upper side wall of the CVD chamber.

At the second step, then, the RF is applied to the second RF electrode provided on the side wall of the CVD chamber, for example, separately from the RF electrode and is thus discharged. Consequently, it is possible to carry out the plasma cleaning over the side surfaces and back faces of the RF electrode and the counter electrode stage and the side wall of the CVD chamber.

In addition, in this case, the discharge is not carried out between the RF electrode and the counter electrode. For this reason, a plasma is not excited between the upper electrode and the counter electrode and it is possible to relieve a damage over the upper electrode and the counter electrode stage.

According to the present invention, moreover, when the deposited film is to be formed on the surface of the substrate and the cleaning gas is to be then introduced to carry out the plasma cleaning over the inside of the CVD chamber, the RF having a comparatively low frequency of 13. 56MHz as the first frequency is applied to the RF electrode at the first step. Consequently, a plasma having a high density is generated on the condition that a small damage is caused over the counter electrode stage. Thus, it is possible to remove most of the by-product such as SiO₂ or Si₃N₄ which is stuck and deposited onto the surface of the internal wall, the electrode or the like in the CVD chamber in the film forming process.

After most of the by-product is removed at the first step, the RF having a comparatively high frequency of 60 MHz as the second frequency is applied to the RF electrode at the second step. Consequently, it is possible to completely remove the residual by-product which is stuck.

In addition, the plasma cleaning at the second step is carried out in a short time. Consequently, it is possible to relieve a damage over the upper electrode and the counter electrode stage. Thus, the present invention can produce many remarkable and peculiar functions and advantages, which is very excellent.

## Claims

1. A method of cleaning a chemical vapour deposition (CVD) apparatus comprising a CVD chamber, an RF electrode for applying an RF into the CVD chamber, and a counter electrode stage which is opposed thereto and can mount a substrate for forming a deposited film,
said method comprising introducing a cleaning gas to carry out plasma cleaning over an inside of the CVD chamber after forming a deposited film on a surface of said substrate,
wherein the frequency of the RF applied to the RF electrode is switched into a first frequency to be applied for forming the film and a second frequency to be applied when executing the plasma cleaning, said plasma cleaning comprising:
(i) a first step of applying an RF having a first frequency to the RF electrode to carry out the plasma cleaning; and
(ii) a second step of applying an RF having a second frequency to the RF electrode to carry out the plasma cleaning;
wherein the electrode interval is changed between step (i) and step (ii).

2. The method according to claim 1, wherein the second cleaning frequency is 60 MHz.

3. The method according to claim 1 or claim 2, wherein the first cleaning frequency is 13.56 MHz.

4. The method according to any one of claims 1 to 3, wherein a mixed gas of COF₂ and O₂ is used as the cleaning gas.

5. The method according to any one of claims 1 to 3, wherein an F₂ gas, a mixed gas of F₂ and O₂, a mixed gas of F₂ and Ar or a mixed gas of F₂ and N₂ is used as the cleaning gas.

6. A chemical vapour deposition (CVD) apparatus for carrying out the method of claim 1 comprising:
a CVD chamber, an RF electrode for applying an RF into the CVD chamber and a counter electrode stage which is opposed thereto and is capable of mounting a substrate for forming a deposited film; means for switching an RF applied to the RF electrode into a first frequency for forming a film and a second frequency for executing the plasma cleaning;
means for applying an RF having a first frequency to the RF electrode to carry out the plasma cleaning;
means for applying an RF having a second frequency to the RF electrode to carry out the plasma cleaning and
means for changing the electrode interval.

## Patentansprüche

1. Verfahren zum Reinigen einer chemischen Gasphasenabscheidungsanlage (CVD-Anlage), umfassend eine CVD-Kammer, eine HF-Elektrode zum Anlegen einer HF in der CVD-Kammer und eine Gegenelektrodenstufe, die dieser gegenüberliegt und ein Substrat zum Bilden eines abgeschiedenen Films montieren kann,
wobei das Verfahren das Einführen eines Reinigungsgases zum Durchführen einer Plasmareinigung über einer Innenseite der CVD-Kammer nach dem Bilden eines abgeschiedenen Films auf einer Oberfläche des Substrats umfasst,
wobei die Frequenz der HF, die an die HF-Elektrode angelegt wird, in eine erste Frequenz geschaltet wird, die zum Bilden des Films angelegt wird, und eine zweite Frequenz, die beim Ausführen der Plasmareinigung angelegt wird, wobei die Plasmareinigung umfasst:
(i) einen ersten Schritt des Anlegens einer HF, die eine erste Frequenz aufweist, an die HF-Elektrode, um die Plasmareinigung auszuführen; und
(ii) einen zweiten Schritt des Anlegens einer HF, die eine zweite Frequenz aufweist, an die HF-Elektrode, um die Plasmareinigung auszuführen;
wobei das Elektrodenintervall zwischen Schritt (i) und Schritt (ii) verändert wird.

2. Verfahren nach Anspruch 1, wobei die zweite Reinigungsfrequenz 60 MHz beträgt.

3. Verfahren nach Anspruch 1 oder Anspruch 2, wobei die erste Reinigungsfrequenz 13,56 MHz beträgt.

4. Verfahren nach einem der Ansprüche 1 bis 3, wobei ein Mischgas aus COF₂ und O₂ als das Reinigungsgas verwendet wird.

5. Verfahren nach einem der Ansprüche 1 bis 3, wobei als Reinigungsgas ein F₂-Gas, ein Mischgas aus F₂ und O₂, ein Mischgas aus F₂ und Ar oder ein Mischgas aus F₂ und N₂ verwendet wird.

6. Chemische Gasphasenabscheidungsanlage (CVD-Anlage) zum Ausführen des Verfahrens nach Anspruch 1, umfassend:
eine CVD-Kammer, eine HF-Elektrode zum Anlegen einer HF in der CVD-Kammer und eine Gegenelektrodenstufe, die dieser gegenüberliegt und ein Substrat zum Bilden eines abgeschiedenen Films montieren kann; Mittel zum Schalten einer HF, die an die HF-Elektrode angelegt wurde, in eine erste Frequenz zum Bilden eines Films und eine zweite Frequenz zum Ausführen der Plasmareinigung;
Mittel zum Anlegen einer HF, die eine erste Frequenz aufweist, an die HF-Elektrode zum Durchführen der Plasmareinigung;
Mittel zum Anlegen einer HF, die eine zweite Frequenz aufweist, an die HF-Elektrode zum Durchführen der Plasmareinigung und
Mittel zum Verändern des Elektrodenintervalls.

## Revendications

1. Procédé de nettoyage d'un appareil de dépôt chimique en phase vapeur (CVD) comprenant une chambre de CVD, une électrode RF pour appliquer une RF dans la chambre de CVD, et un étage de contre-électrode qui est opposé à celle-ci et peut accueillir un substrat pour former un film déposé,
ledit procédé comprenant l'introduction d'un gaz de nettoyage pour effectuer un nettoyage par plasma sur un intérieur de la chambre de CVD après formation d'un film déposé sur une surface dudit substrat,
dans lequel la fréquence de la RF appliquée à l'électrode RF est commutée dans une première fréquence devant être appliquée pour former le film et une seconde fréquence devant être appliquée lors de l'exécution du nettoyage par plasma, ledit nettoyage par plasma comprenant :
(i) une première étape d'application d'une RF ayant une première fréquence à l'électrode RF pour effectuer le nettoyage par plasma ; et
(ii) une seconde étape d'application d'une RF ayant une seconde fréquence à l'électrode RF pour effectuer le nettoyage par plasma ;
dans lequel l'intervalle entre électrodes est changé entre l'étape (i) et l'étape (ii).

2. Procédé selon la revendication 1, dans lequel la seconde fréquence de nettoyage est de 60 MHz.

3. Procédé selon la revendication 1 ou la revendication 2, dans lequel la première fréquence de nettoyage est de 13,56 MHz.

4. Procédé selon l'une quelconque des revendications 1 à 3, dans lequel un gaz mélangé de COF₂ et d'O₂ est utilisé en tant que gaz de nettoyage.

5. Procédé selon l'une quelconque des revendications 1 à 3, dans lequel un gaz F₂, un gaz mélangé de F₂ et d'O₂, un gaz mélangé de F₂ et d'Ar ou un gaz mélangé de F₂ et de N₂ est utilisé en tant que gaz de nettoyage.

6. Appareil de dépôt chimique en phase vapeur (CVD) pour effectuer le procédé selon la revendication 1, comprenant :
une chambre de CVD, une électrode RF pour appliquer une RF dans la chambre de CVD, et un étage de contre-électrode qui est opposé à celle-ci et peut recevoir un substrat pour former un film déposé ; des moyens pour commuter une RF appliquée à l'électrode RF dans une première fréquence pour former un film et une seconde fréquence pour exécuter le nettoyage par plasma ;
des moyens pour appliquer une RF ayant une première fréquence à l'électrode RF pour effectuer le nettoyage par plasma ;
des moyens pour appliquer une RF ayant une seconde fréquence à l'électrode RF pour effectuer le nettoyage par plasma et
des moyens pour changer l'intervalle entre électrodes.
